# EUROPEAN PATENT SPECIFICATION

(11) **EP 3 317 896 B1**
(45) Date of publication and mention of the grant of the patent: **07.05.2025**
(21) Application number: 16733467.1
(22) Date of filing: 28.06.2016
(51) Int. Cl.: H01L 23/00, H01L 21/58, H01L 23/48, H01L 21/60

(54) **A SURFACE MOUNT DEVICE AND A METHOD OF ATTACHING SUCH A DEVICE**
OBERFLÄCHENMONTIERTE VORRICHTUNG UND VERFAHREN ZUR BEFESTIGUNG SOLCH EINER VORRICHTUNG
DISPOSITIF À MONTAGE EN SURFACE ET PROCÉDÉ DE FIXATION D'UN TEL DISPOSITIF

(30) Priority: 02.07.2015 EP 15174960
(43) Date of publication of application: 09.05.2018
(73) Proprietor: Lumileds LLC, San Jose, CA 95131 (US)
(72) Inventor: NOIJEN, Sander, 52068 Aachen (DE); UBACHS, Rene, 52068 Aachen (DE); VAN DER SLUIS, Olaf, 52068 Aachen (DE)
(74) Representative: dompatent von Kreisler Selting Werner - Partnerschaft von Patent- und Rechtsanwälten mbB
(86) International application number: PCT/EP2016/064940
(87) International publication number: WO 2017/001369

(56) References cited:
- GB-A- 2 521 619
- US-A- 5 949 654
- US-A1- 2003 042 626
- US-A1- 2007 210 447
- US-A1- 2007 228 110
- US-A1- 2014 252 584
- US-B1- 6 441 485
- US-B1- 7 683 494

## Description

### FIELD OF THE INVENTION

This invention relates to a method of forming a device comprising a surface mount devices.

### BACKGROUND OF THE INVENTION

Surface mounted devices are connected to printed circuit boards by solder interconnects or adhesive materials. These materials serve an electrical, a thermal and a mechanical purpose. In both die-attach methods as well as component-attach methods, the materials used are selected to fulfill stringent electrical and thermal requirements. Once these requirements are met for specific materials, the mechanical reliability of the interconnect is optimized.

This optimization is a challenging task for both adhesive materials and for solder materials. Most adhesive materials have a low stiffness and are mechanically compliant, but can only withstand a limited thermal load due to their low thermal conductivity. Most solder materials have higher moduli, but suffer from low cycle fatigue when operating at typical usage temperatures.

This shows that there is a trade-off between the electrical, thermal and mechanical design of the interconnect. This trade-off hampers the individual optimization of electrical, thermal and mechanical functions.

Document US 6,441,485 B1 discloses an apparatus for mounting an electronic device that has an array of interconnection balls or other electrically conductive contacts on a substrate such as a PCB, without requiring soldering or underfill.

US 7,683,494 B1 describes a press-fit integrated circuit packaging, without the involvement of wire-bonding and flip-chip bond bump forming processing steps.

US 2007/0228110 A1 discloses a method of mounting an electronic component onto a substrate such as a PCB, whereby the component is held in place by spring clips that are manufactured with coated wires; the terminals of the component are electrically connected to the pads of the PCB by solder or electrically conductive adhesive; an embodiment also discloses providing a thermally conductive adhesive between the component and the substrate.

US 2014/0252584 and GB 2521619 A disclose methods using 3D additive manufacturing technologies for forming interconnections between a component and a substrate.

### SUMMARY OF THE INVENTION

The invention is set out in the appended set of claims.

According to examples in accordance with an aspect of the invention, there is provided a method of forming a device comprising:
a surface mount component; and
a substrate,
wherein the surface mount component is attached to the substrate by a set of discrete mechanical coupling parts and by a bonding layer, wherein the surface mount component and the mechanical coupling parts are connected by a clamp or clicking system. Said mechanical coupling parts are formed as integral components with the substrate, or formed directly over the substrate and wherein the surface mount component is a snap fit to the mechanical coupling parts. The mechanical coupling parts provide a statically determinate coupling between the substrate and the surface mount component by the clamp or clicking system.

The mechanical coupling parts are created by 3D printing on the substrate or 3D machining of the substrate, and can separate the mechanical connection function from the electrical and thermal connection functions, which makes it possible to optimize these functions individually. The bonding layer may be designed to provide both electrical and thermal interconnection, or it may specifically be designed for its thermal characteristics. Separate electrical connections may then be provided.

The invention makes it possible to optimize the thermal/electrical properties and the mechanical lifetime separately, exploiting the specific benefits of individual materials, and no longer requiring the trade-off between function and reliability.

The mechanical coupling parts may for example comprise planar interconnection pieces, such as as a bar (or strut or sprit), or arrangement of bars, or a sheet structure lying within the plane.

The bonding layer may comprise a single connecting region or it may have separate isolated portions. The bonding layer may for example be an electrically and thermally conductive adhesive layer. It may then perform both electrical and thermal functionality. The bonding layer may instead comprise one or more solder connections. There may be an additional layer, for example solder connections forming a first bonding layer designed primarily for the electrical connection properties and an adhesive layer forming a second bonding layer designed primarily for the thermal coupling properties.

The mechanical part is optimized by creating a statically determinate fixation. This means that each degree of freedom of the surface mount device is uniquely constrained. This avoids self-stress on the structure due to e.g. thermal loading.

The mechanical coupling can be made at room temperature. Consequently, the disadvantages of high temperature processing are removed, for example exceeding melting points of materials or high thermal stresses. This makes its process compliant with any substrate, die or component, each of which often has maximum processing temperatures.

The surface mount component for example comprises at least one electrical contact pad at a base surface of the component which is connected to the substrate by a conductive adhesive layer. This base contact means that the connection between the surface mount component and the substrate needs to be electrically conductive (unlike the case for a surface mount component where all connections are made by leads extending laterally away from the main body of the device). The electrical contact pad may for example be a ground contact.

The surface mount component may instead comprise a discrete component with a set of at least two contact terminals which extend to the base surface. There may for example be contact terminals at opposite ends of the device which connect down to the substrate. Alternatively, there may be an array of contact pads at the base of the surface mount component.

In another arrangement, the surface mount component comprises a semiconductor component, wherein the semiconductor die is connected to the substrate by the conductive adhesive layer. This is for a die-attach process. In this case, the base of the surface mount component may not be a contact pad as such, but it may be a semiconductor layer.

In one example, the bonding layer may comprise an adhesive with embedded conducting particles. The use of a solder may then be avoided by removing the requirement for a strong mechanical coupling of the thermal and/or electrical connection. This in turn means that lower temperature processes may be used.

The bonding layer may instead comprise a solder connection or an array of solder connections, but with relaxed mechanical requirements.

The mechanical coupling parts used in the method of the invention may thus be used to (partly) replace the mechanical function of a system which additionally uses solder connections, or a system having a conductive adhesive. The arrangement obtainable with the method of the invention may thus be combined with a solder or with a conductive adhesive. However, these connections no longer need to be designed to carry the mechanical load.

One or more of the mechanical coupling parts may be embedded in the bonding layer. The bonding layer is applied after the mechanical coupling parts have been formed.

The mechanical coupling parts may each comprise one of:
a connecting bar such as a strut or sprit;
a pair of crossed connecting bars;
a pad which defines a leaf spring;
a patterned pad which defines a restricted leaf spring.

The mechanical coupling part designs, their number, orientations and positions are for example selected to provide a statically determinate coupling between the substrate and the surface mount component.

The substrate may comprise:
a semiconductor substrate; or
a printed circuit board; or
a lead frame; or
a flex-foil.

Thus, the invention has wide applicability to surface mount technology generally.

The mechanical coupling parts are formed as integral components with the substrate or formed directly on the substrate. This is achieved by 3D machining of the substrate to define the mechanical coupling parts in the top surface. Alternatively, the mechanical coupling parts may be 3D printed on the top surface of the substrate, or by 3D printing the complete substrate or part of it.

The mechanical coupling parts do not necessarily play a role in the electrical and thermal interconnection between the component and the substrate.

A method of manufacturing a device according to the invention is defined in the appended claims.

### BRIEF DESCRIPTION OF THE DRAWINGS

Examples of the invention will now be described in detail with reference to the accompanying drawings, in which:
Figure 1 shows a known surface mount device attached to a substrate;
Figure 2 shows a first example of a surface mount device attached to a substrate; this example can be manufactured with the method of the invention;
Figure 3 shows a second example of surface mount device attached to a substrate; this example can be manufactured with the method of the invention;
Figure 4 shows three possible designs of mechanical coupling parts, which can be used in the method of the invention;
Figure 5 shows four different coupling arrangements, which may be implemented with the method of the invention;
Figure 6 shows a snap fit coupling arrangement, which may be implemented with the method of the invention; and
Figure 7 shows a manufacturing method according to the invention.

### DETAILED DESCRIPTION OF THE EMBODIMENTS

The invention provides a method of manufacturing a device as defined in claim 1, the device comprising a surface mount component on a substrate, in which the surface mount component is attached by a set of discrete mechanical coupling parts and by a bonding layer, such as a conductive adhesive layer or a solder layer or solder portions. This enables the mechanical coupling properties and the electrical/thermal properties to be optimized separately.

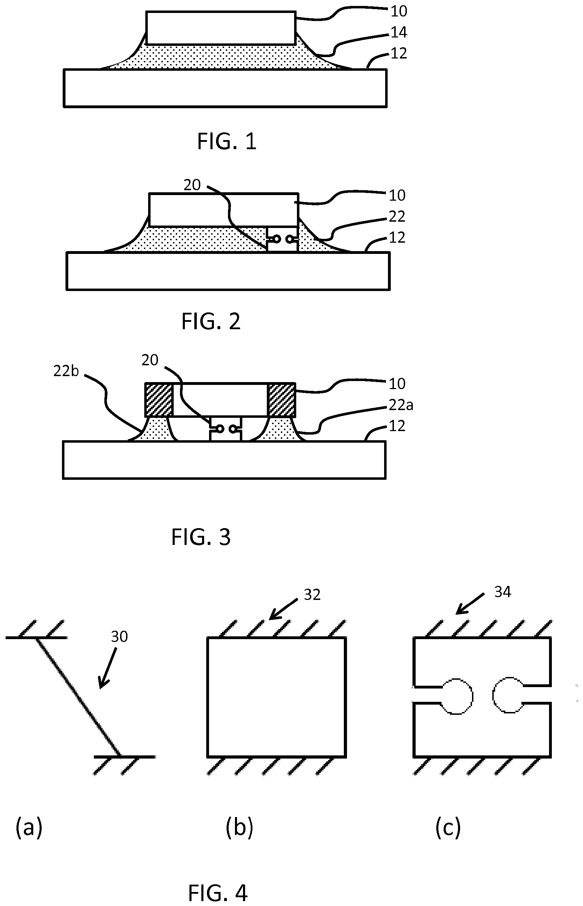

Figure 1 shows a conventional surface mount device 10 connected to a substrate 12 using a solder or adhesive layer 14 which performs the interconnect function. It has to meet thermal, electrical and mechanical requirements.

Figure 2 shows an example of an arrangement that can be manufactured with the method of the invention. The interconnection function is shared between two parts. A first mechanical coupling part 20 provides a mechanical coupling. A second part 22 is a soft bonding material layer which meets thermal and electrical requirements, but does not need to provide a secure mechanical coupling.

Alternatively, there may be three parts; a mechanical coupling part 20, an electrical connection such as a solder connection or wire connections, which do not need to be designed to provide the full mechanical or thermal support, and an adhesive layer which provides primarily a thermal function.

The invention is of particular interest for a surface mount technology in which an electrically conductive coupling is needed between the main body of the surface mount device and the underlying substrate, i.e. when the base of the surface mount device includes regions to which electrical contact is needed.

This applies to a semiconductor device on a semiconductor die, in which the die needs to be electrically connected to a controlled potential in order to avoid floating potentials. Thus, the electrical connection may not be to a contact pad as such but may be to a semiconductor die (in a die-attach surface mount process).

This also applies to an electrical component (which may be active or passive) with contact terminals at its base. For example, a surface mount capacitor may have terminals at the ends, which extend down to the bottom surface layer.

This also applies to an electronic component with a ground terminal at its base, in addition to other terminals which may for example be provided by contact leads.

This also applies to an electronic component with a set of contact terminals at its base and these may be the only contact terminals to the component.

In some other examples, a component may have the required electrical connection implemented by connecting wires or leads or by solder ball connections such as a ball grid array. In this case, the remaining thermal and mechanical functions may be decoupled by using the mechanical coupling parts and the bonding layer which then does not need to be electrically conductive. The invention is however of particular interest for surface mount devices without leads.

The examples above show that a conductive adhesive layer may be a single layer as shown in Figure 2, but it may have different portions 22a, 22b as shown in Figure 3 for electrical connection to different regions of the base of the surface mount component.

The separate portions 22a, 22b may be separate regions of a conductive adhesive layer. Alternatively, the portions 22a, 22b may be solder portions which then define the bonding layer. They then provide thermal as well as electrical coupling. They also provide mechanical coupling but the mechanical properties can be relaxed as a result of the use of the mechanical coupling parts 20.

A separate additional adhesive layer may optionally also be provided in addition to the solder connection and mechanical coupling parts. The additional adhesive layer for example may extend over a larger area than the area of the solder portions.

The connections between the component and the substrate may be considered to be die attach parts which are for thermal and mechanical coupling of the component to the substrate, and component attach parts which are for electrical coupling of the component to the substrate. The mechanical coupling parts function only as a die attach parts and they are designed to provide the required mechanical coupling properties.

The mechanical coupling parts 20 fix the surface mount device 10 to the substrate with a mechanical connection which is statically determinate or approximately statically determinate

A statically determinate structure (otherwise known as "isostatic") is completely constrained and functions as an exact constraint kinematic coupling. Its structure reduces or eliminates the possibility of self-stress, i.e. stress in the absence of an external load, that may be induced by mechanical or thermal action. Thus, the mechanical coupling is able to minimize the internal load interaction between the component 10 and the substrate 12 and eliminates the possibility of self-stress.

Additionally, the mechanical coupling can be designed to be stressed in the elastic range only. The coupling parts in this way only have reversible elastic deformation so that after release of the present load the mechanical coupling reverts back to its original shape. This reduces or eliminates fatigue in the coupling parts which increases lifetime of the parts and the system.

The stress in the mechanical coupling and also in the component itself may be minimized, which maximizes the lifetime.

The bonding layer may function both as a thermal coupling for the component and an electrical attachment. These two functions may be performed by a single design of bonding layer, such as a thermally conductive adhesive, or as separate parts, such as electrical solder connections combined with a thermally coupling bonding layer.

The electrical and thermal functionality is achieved with standard materials, such as standard high conductivity low stiffness materials. One example is an adhesive which is filled with conductive particles. The mechanical properties of these materials are of secondary importance as the mechanical functionality is fulfilled by the mechanical coupling part 20.

The invention thus relates in particular to the mechanical coupling part 20 which enables the elastic (near) statically determinate fixation of the component 10 to the substrate 12.

The development of additive manufacturing technologies (e.g. 3D printing) enables the fabrication of small detailed elastic components such as leaf springs, restricted leaf springs and sprits or struts (which are referred to generally as connecting bars in the text and claims below).

Figure 4(a) shows a diagonal connection strut 30 (known as a sprit). Such a strut may be used as a vertical or a horizontal connector as well. Figure 4(b) shows a leaf spring 32, and Figure 4(c) shows a restricted leaf spring 34. The restricted leaf spring has a pattern formed in its surface to define channels. These alter the spring characteristics. The channels allow relative rotation of the top and bottom edges of the leaf spring. Note that a pair of crossed struts functions in the same way as a restricted leaf spring.

These structures are each planar (although the crossed struts may have a thicker central part), and they allow some elastic deformation perpendicular to the plane.

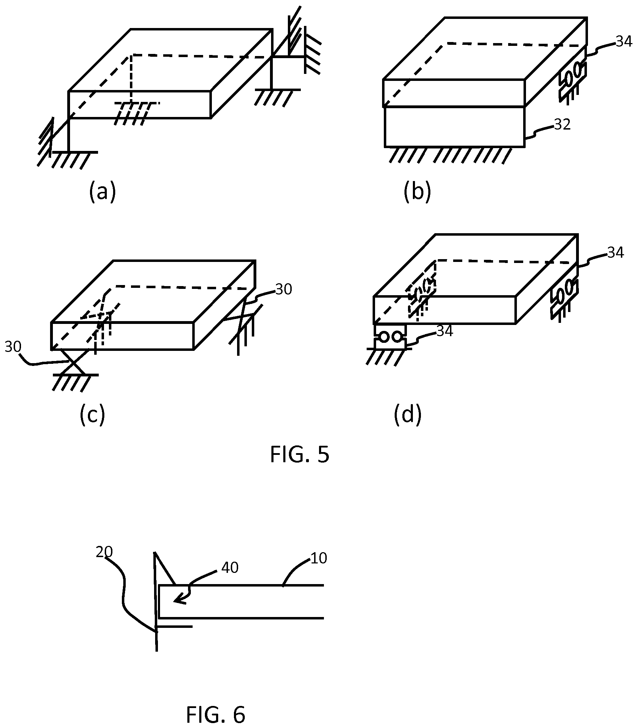

Figure 5 shows various possible connection schemes to provide a statically determinate structure.

Figure 5(a) shows a set of three vertical couplings between the two components as well as a set of three lateral couplings. The mechanical coupling parts are all connecting bar couplings.

Figure 5(b) shows a set of two vertical couplings between the two components in which one comprises a restricted leaf spring 34 and the other comprises a full leaf spring. They are vertical but they are orthogonal to each each other. The full leaf spring extends across the full width of one side of the component, so that only two mechanical coupling parts are needed to form the desired statically determinate structure.

Figure 5(c) shows a set of three vertical couplings between the two components, each in the form of a pair of crossed bars 30.

Figure 5(d) shows a set of three vertical couplings between the two components, each in the form of a restricted leaf spring 34.

The number of mechanical coupling parts is unrelated to the number of electrical connections between the component and the substrate. There may for example be exactly two or three mechanical coupling parts as shown in the examples above, in which one mechanical coupling part is taken to comprise all of the parts which attach to a particular location of the component. For example, Figure 5(a) shows three mechanical coupling parts; one at each of three corners of the components. Figure 5(b) shows two mechanical coupling parts, one along one edge of the component and one at another corner.

The mechanical coupling parts may be conductive or insulating. They connect to regions of the component away from (i.e. excluding) electrical contact terminals, for example insulating regions of the component.

The height of the mechanical coupling parts is designed such that the components are only loaded in the elastic range. As explained above, the mechanical coupling parts are created by 3D printing on the substrate, or 3D machining of the substrate itself.

The connection between the surface mount component 10 and the mechanical coupling parts 20 is made by a clamp or clicking system. A possible solution is shown in Figure 6.

The surface mount component 10 is a snap fit in a retaining channel 40 formed as part of the mechanical coupling part 20.

The invention can be applied to any surface mount device or die that needs to be attached to a substrate, wherein the substrate may be a printed circuit board, a flex-foil, or a lead frame for example.

The mechanical coupling parts may for example be plastic parts formed by 3D printing.

The mechanical coupling parts may have dimensions of 10-300 µm height and width in the same range, for example identical height and width. Thickness of the parts may be approximately 1-10 micrometers.

Thus, the mechanical coupling parts are planar structures, by which is meant that the thickness is at most 1/10 of the largest in-plane dimension, and the shape is generally flat, although not necessarily perfectly planar. In the case of struts as in Figure 4(a), they are again planar in that the thickness is at most 1/10 of the length (which is the largest in-plane dimension). A strut may be considered to be a 1 dimensional connection and a leaf spring or crossed strut arrangement may be considered to be a 2 dimensional connection.

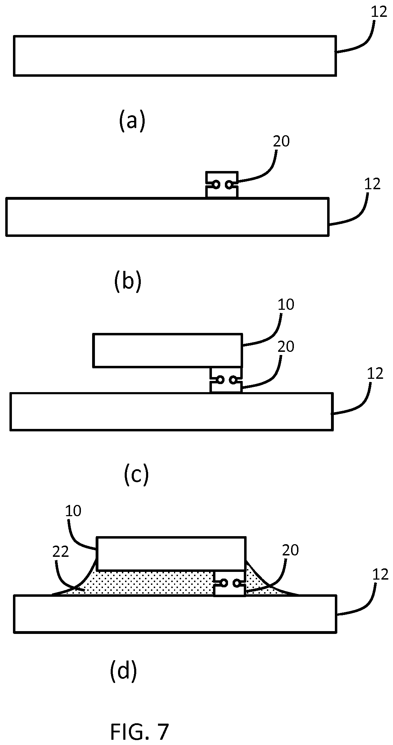

Figure 7 shows a manufacturing method.

Figure 7(a) shows a substrate 12, which may be a semiconductor substrate, a printed circuit board, a lead frame or a flex foil.

The mechanical coupling part 20 is formed by layer deposition over the substrate, by a 3D printing process, to provide the structure shown in Figure 7(b).

As shown in Figure 7(c) the surface mount component is attached to the mechanical coupling part 20, by a snap fit coupling.

The adhesive layer is then injected as shown in Figure 7(d).

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality.

## Claims

1. A method of manufacturing a device, comprising:
mounting a surface mount component (10) to a substrate (12) using a set of discrete mechanical coupling parts (20;30;32;34),
the surface mount component (10) and the mechanical coupling parts (20;30;32;34) being connected by a clamp or clicking system such that the surface mount component (10) is a snap fit to the mechanical coupling parts, and
the method further comprises
forming the mechanical coupling parts (20;30;32;34) as integral components with the substrate or directly over the substrate and providing a statically determinate coupling between the substrate and the surface mount component; and
after mounting the surface mount component to the substrate providing a bonding layer (22) providing electrical and/or thermal interconnection between the surface mount component and the substrate;
the method being **characterized in that** the mechanical coupling parts (20; 30; 32; 34) are formed by 3D printing on the substrate (12) or by 3D machining of the substrate (12).

2. A method as claimed in claim 1, wherein providing the bonding layer comprises providing a conductive adhesive layer (22).

## Patentansprüche

1. Verfahren zur Herstellung einer Vorrichtung mit den Schritten:
Montieren einer Aufbaukomponente (10) auf ein Substrat (12) unter Verwendung eines Satzes diskreter mechanischer Kopplungsteile (20, 30, 32, 34),
wobei die Aufbaukomponente (10) und die mechanischen Kopplungsteile (20, 30, 32, 34) durch ein Klemm- oder Klicksystem derart verbunden sind, dass die Aufbaukomponente (10) schnappend mit den mechanischen Kopplungsteilen verbunden sind, und
das Verfahren ferner die folgenden Schritte aufweist:
Ausbilden der mechanischen Kopplungsteile (20, 30, 32, 34) als einstückige Komponenten mit dem Substrat oder direkt über dem Substrat und Vorsehen einer statisch bestimmten Kopplung zwischen dem Substrat und der Aufbaukomponente; und
nach dem Montieren der Aufbaukomponente auf das Substrat, Vorsehen einer Bonding-Schicht (22), welche eine elektrische und/oder thermische Verbindung zwischen der Aufbaukomponente und dem Substrat bereitstellt;
wobei das Verfahren **dadurch gekennzeichnet ist, dass** die mechanischen Kopplungsteile (20, 30, 32, 34) durch 3D-Drucken auf dem Substrat (12) oder durch 3D-Bearbeitung des Substrats (12) gebildet werden.

2. Verfahren nach Anspruch 1, bei welchem das Vorsehen der Bonding-Schicht das Vorsehen einer leitfähigen Kleberschicht (22) umfasst.

## Revendications

1. Procédé permettant de fabriquer un dispositif, comprenant :
le montage d'un composant de montage en surface (10) sur un substrat (12) à l'aide d'un ensemble de pièces d'accouplement mécanique
discrètes (20 ;30 ;32 ;34),
le composant de montage en surface (10) et les pièces d'accouplement mécanique (20 ;30 ;32 ;34) étant reliés par un système de serrage ou d'encliquetage de telle sorte que le composant de montage en surface (10) s'ajuste par encliquetage aux pièces d'accouplement mécanique, et le procédé comprend en outre :
la formation des pièces d'accouplement mécanique (20 ;30 ;32 ;34) en tant que composants intégrés au substrat ou directement sur le substrat et assurant un accouplement statiquement déterminé entre le substrat et le composant de montage en surface ; et
après avoir monté le composant de montage en surface sur le substrat, la fourniture d'une couche de liaison (22) assurant l'interconnexion électrique et/ou thermique entre le composant de montage en surface et le substrat ; le procédé étant **caractérisé en ce que** les pièces d'accouplement mécanique (20 - 30 ; 32 - 34) sont formées par impression 3D sur le substrat (12) ou par usinage 3D du substrat (12).

2. Procédé selon la revendication 1, dans lequel la fourniture de la couche de liaison comprend la fourniture d'une couche adhésive conductrice (22).
